# EUROPÄISCHE PATENTSCHRIFT

(11) **EP 0 739 539 B1**
(45) Veröffentlichungstag und Bekanntmachung des Hinweises auf die Patenterteilung: **22.07.1998**
(21) Anmeldenummer: 95905037.8
(22) Anmeldetag: 03.01.1995
(51) Int. Cl.: H01L 21/768

(54) **VERFAHREN ZUM FÜLLEN VON KONTAKTLÖCHERN**
PROCESS FOR FILLING CONTACT HOLES
PROCEDE DE REMPLISSAGE DE TROUS DE METALLISATION

(30) Priorität: 11.01.1994 DE 4400532
(43) Veröffentlichungstag der Anmeldung: 30.10.1996
(73) Patentinhaber: SIEMENS AKTIENGESELLSCHAFT, 80333 München (DE)
(72) Erfinder: HÜBNER, Holger, D-85598 Baldham (DE)
(86) Internationale Anmeldenummer: DE9500009
(87) Internationale Veröffentlichungsnummer: WO9519045

(56) Entgegenhaltungen:
- EP-A- 0 435 187
- EP-A- 0 610 709
- PATENT ABSTRACTS OF JAPAN vol. 013 no. 594 (E-867) ,27.Dezember 1989 & JP,A,01 248592 (HITACHI LTD) 4.Oktober 1989,

## Beschreibung

Die vorliegende Erfindung betrifft ein Verfahren zum Füllen von Kontaktlöchern in der Oberseite eines Halbleiterbauelementes.

In der früheren europäischen Patentanmeldung EP 0 610 709 A1, die zum Stand der Technik nach Artikel 54(3) EPÜ gehört, wird ein Bauelement beschrieben, das aus einem Stapel mehrerer übereinander angeordneter und mit Kontakten verbundener Schaltungsebenen besteht. Die vertikalen Kontakte zwischen den Schaltungsebenen werden realisiert, indem man ein flüssiges Metall, z. B. Gallium, in vorgefertigte und mit einer festen Metallschicht ausgekleidete Löcher gießt. Die beiden Metalle legieren zusammen und bilden eine feste Verbindung, die den elektrischen und mechanischen Kontakt bildet. Die Oberfläche einer solchen mit Kontaktlöchern versehenen Schaltungsebene besteht kurz vor dem Aufbringen des Flüssigmetalls zum überwiegenden Teil aus einer von dem Metall nicht benetzbaren Polyimidschicht, in der sich die Kontaktlöcher, die wenige Mikrometer groß sind, befinden. An den Wandungen sind die Kontaktlöcher mit einer von dem Flüssigmetall benetzbaren Metallschicht (bei Verwendung von Gallium für das Flüssigmetall z. B. Nickel oder Kupfer) versehen. Das Flüssigmetall soll so in die Kontaktlöcher verbracht werden, daß sie anschließend vollständig gefüllt sind und die Oberfläche der Polyimidschicht trocken bleibt. Über den Kontaktlöchern sollen sich jeweils kleine Menisken des Flüssigmetalles bilden, die für die vorgesehene Anwendung ausreichend hoch über die Oberfläche hinausragen. Die Ausbildung der Menisken muß über die gesamte Oberfläche hinweg sehr konstant erfolgen, wobei zusätzlich eine gute Reproduzierbarkeit von Wafer zu Wafer erzielt werden soll. Außerdem muß zuverlässig vermieden werden, daß auf der Polyimidoberfläche Reste des Flüssigmetalles haften bleiben, die beim Zusammenfügen der Schaltungsebenen möglicherweise zu Kurzschluß führen. Es ist z. B. möglich, wie in der angegebenen Patentanmeldung beschrieben, das Flüssigmetall aufzugießen und anschließend die an der Oberfläche über den nicht benetzbaren Polyimidflächen sich bildenden Tropfen durch eine Drehbewegung des Wafers abzuschleudern. Dabei kann es vorkommen, daß die sehr kleinen und sehr eng benachbart angeordneten Kontaktlöcher auch nach dem Abschleudern des überschüssigen Flüssigmetalls zumindest in einzelnen Fällen an der Oberfläche durch Stege aus dem Flüssigmetall elektrisch leitend verbunden bleiben. An den Stellen, an denen die Polyimidschicht nicht perfekt ist, z. B. Stufen oder Risse aufweist, können Tropfen des Flüssigmetalles haften bleiben und zu Kurzschlüssen führen, wenn sie beim Zusammenfügen der Schaltungsebenen in den dünnen Spalt zwischen den Ebenen gepreßt werden.

In der JP-A-1 248 592 ist ein Verfahren beschrieben, mit dem Kontaktlöcher mit elektrisch leitender Paste gefüllt werden. Die Paste wird mittels angeschrägter Quetschwalzen in die Löcher hineingedrückt. Bei Bedarf ist dazu die Quetschwalze in zwei verschiedenen Winkeln angeschrägt. Bei Verwendung einer gering viskosen Paste genügt eine Anschrägung in nur einem Winkel.

Aufgabe der vorliegenden Erfindung ist es, ein Verfahren zum Füllen von Kontakt löchern in der Oberseite von Halbleiterbauelementen mit einem Flüssigmetall anzugeben, bei dem die vorgenannten Schwierigkeiten nicht auftreten.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Verfahren wird das Flüssigmetall mit einer Rakel, ähnlich wie sie beim Siebdruck verwendet wird, aufgetragen. Eine solche Rakel ist ein breites, dünnes Band z. B. aus Metall ähnlich einer geradlinig parallel berandeten Messerklinge. Durch Aufsetzen einer Längskante dieser Rakel kann das Flüssigmetall über die Oberfläche des Bauelementes verteilt werden. Wesentlich bei dem erfindungsgemäßen Verfahren ist es, daß die Rakel in einem gewissen kleinen Abstand über der Oberfläche des Bauelementes bewegt wird. Das Flüssigmetall, im folgenden stellvertretend als Gallium bezeichnet, wird dabei walzenförmig zwischen der Oberfläche und der Kante und ggf. den unteren Seitenflächen der Rakel bewegt. Dabei spielen die physikalischen verhältnisse an einer gekrümmten Oberfläche einer Flüssigkeit eine Rolle. Die Oberfläche einer Flüssigkeit bildet sich so aus, daß sie überall die durch den inneren Druck festgelegte Krümmung aufweist. Der Druck an einem Punkt der Oberfläche der Flüssigkeit ist proportional zur Summe der reziproken Werte der beiden Hauptkrümmungsradien der Oberflache in diesem Punkt. Bei großen Flüssigkeitstropfen auf einer Oberfläche muß noch der hydrostatische Druck berücksichtigt werden. An den Rändern, wo die Flüssigkeit mit der ebenen Oberfläche der Unterlage in Kontakt tritt, bildet die Tangentialebene an die Flüssigkeitsoberfläche mit der Unterlage einen Winkel, der im Fall einer nicht benetzbaren Unterlage 0 bis 90° beträgt und im Fall einer benetzbaren Unterlage 90° bis 180°, wobei der Winkel außerhalb der Flüssigkeit gemessen wird.

Die weitere Beschreibung des erfindungsgemäßen Verfahrens erfolgt anhand der Figuren 1 bis 6.
- Fig. 1: zeigt die Anwendung der Rakel bei der Durchführung des Verfahrens.
- Fig. 2: zeigt ein mit dem Gallium gefülltes Kontaktloch im Querschnitt.
- Fig. 3 bis 5: zeigen das Bauelement und die Rakel bei unterschiedlichen Anwendungen des Verfahrens im Querschnitt.
- Fig. 6: zeigt den in Fig. 1 gestrichelt gezeichneten Ausschnitt in Vergrößerung.

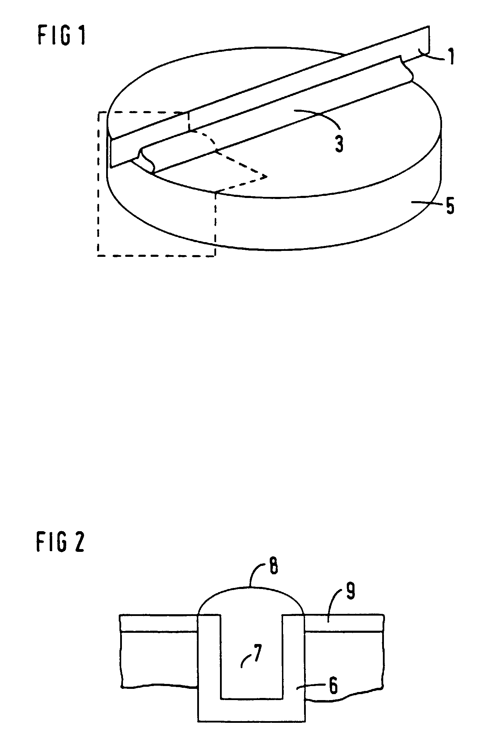

Die Rakel 1 hat, wie in Fig. 1 dargestellt, eine Länge, die den Durchmesser der Halbleiterscheibe 5 etwas überragt. An der unteren Längskante besteht sie aus einem Material, das von dem Gallium benetzt wird, ohne mit ihm zu legieren, wie z. B. Aluminium oder SiO₂. Das Gallium 3 hängt daher von der unteren Längskante der Rakel 1 in Form einer Walze mit tropfenförmigem Querschnitt herab. Zum Füllen der Kontaktlöcher wird die Rakel in einem so geringen Abstand über die Oberfläche des Bauelementes 5 geführt, ohne es jedoch zu berühren, daß die Galliumwalze mit der Oberfläche des Bauelementes 5 in Berührung kommt. Beim Überstreichen der Kontaktlöcher werden diese durch das Gallium gefüllt, weil die Wandungen und Ränder der Kontakt löcher mit einem Material beschichtet sind, das durch das Gallium benetzt wird.

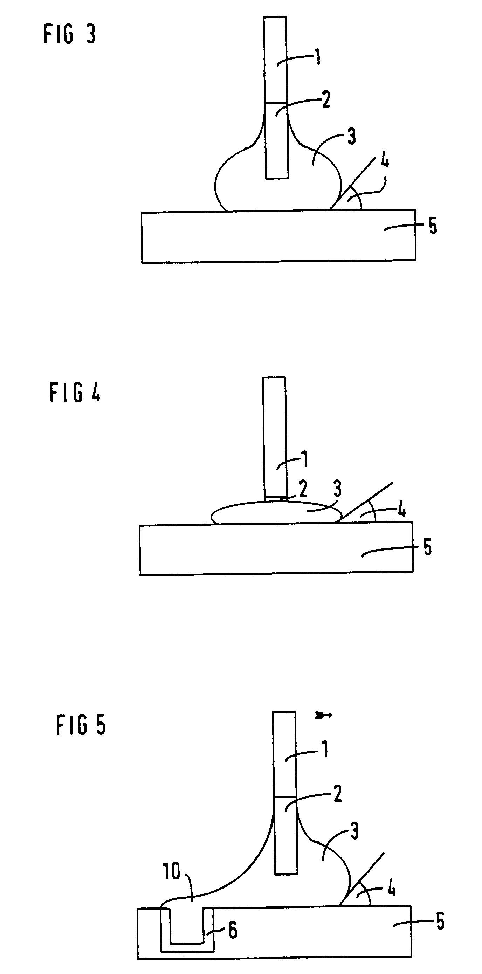

Fig. 2 zeigt ein gefülltes Kontaktloch im Querschnitt. Die Wandung ist mit einer Metallisierung 6 bedeckt, die z. B. Nickel oder Kupfer sein kann, wenn das eingefüllte Material des Flüssigkontaktes 7 Gallium ist. Die an das Kontaktloch angrenzenden Bereiche der Oberfläche sind mit einer passivierenden Schicht 9 bedeckt, die von dem Gallium nicht benetzt wird. Diese passivierende Schicht 9 kann z. B. Polyimid sein. Der über die Oberfläche hinausragende Anteil des Flüssigkontakes 7 bildet einen Meniskus 8. Die Höhe des Meniskus 8 hängt zusammen mit der Höhe des Druckes in der Galliumwalze beim Auffüllen der Kontaktlöcher. Dieser Zusammenhang wird jetzt anhand der Figuren 3 bis 5 erklärt.

Fig. 3 zeigt die Rakel 1 mit dem an der unteren Längskante vorhandenen Adhäsionsstreifen 2 aus Material, das von dem Gallium 3 benetzt wird. In der Fig. 3 ist die Rakel 1 an einer Stelle über der passivierenden Schicht auf der Oberseite des Bauelementes 5 gezeigt, so daß das Gallium 3 diese Oberseite dort nicht benetzt. Der Winkel 4 zwischen der freien Oberseite des Bauelementes 5 und der Tangentialebene an die Oberfläche der Galliumwalze in deren Fußpunkt ist daher kleiner als 90°. Für die Galliumwalze ergibt sich ein tropfenförmiger Querschnitt, der in Längsrichtung der Rakel translationsinvariant ist. Bei der Anordnung der Fig. 4 ist der Abstand zwischen der Rakel 1 und der Oberseite des Bauelementes 5 deutlich kleiner. Außerdem ist der Adhäsionsstreifen 2 auf die untere Kante der Rakel 1 begrenzt. Das Gallium benetzt daher die Seitenflächen der Rakel 1 nicht und wird wie in Fig. 4 gezeigt zusammengedrückt. Der Winkel 4 zwischen der freien Oberseite des Bauelementes 5 und der Tangentialebene an die Oberfläche des Galliums 3 am Rand der Grenzfläche zwischen Gallium 3 und Bauelement 5 ist daher kleiner als der betreffende Winkel bei der Anordnung der Fig. 3.

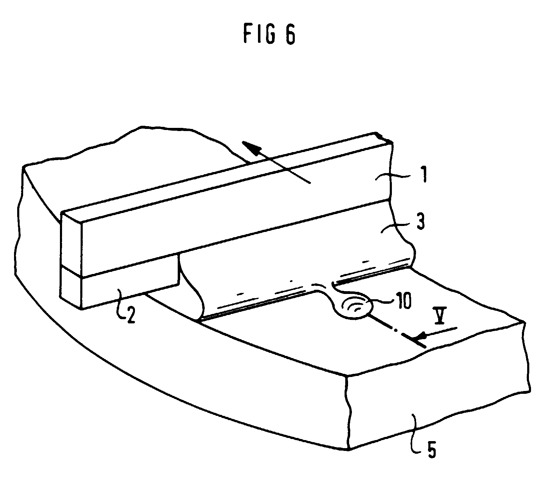

Über der nicht benetzbaren passivierenden Schicht nimmt die Walze des Galliums 3 zumindest prinzipiell die in den Figuren 3 und 4 gezeigte Form ein. Befindet sich die Rakel über einem Kontaktloch, besitzt das Gallium etwa die gleiche Form, denn der Durchmesser des Kontaktloches ist klein gegenüber der Breite der Galliumwalze. Auf einer benetzbaren Oberfläche würde das Gallium 3 lateral zu der Rakel auslaufen, so daß der in den Fig. 3 und 4 eingezeichnete Winkel 4 größer als 90° wäre. Ähnliches ergibt sich über den Kontaktlöchern beim Auslaufen der Walze, wenn die Rakel über das Loch weiterbewegt wird. In Fig. 5 ist das Bauelement 5 im Querschnitt mit einem Kontaktloch gezeigt. Das Kontaktloch ist an den Wänden mit der Metallisierung 6 versehen. Das Gallium benetzt diese Metallisierung und füllt das Kontaktloch auf, wenn die Galliumwalze mit der Rakel über das Loch bewegt wird. Der in Fig. 5 eingezeichnete Pfeil gibt die Bewegungsrichtung der Rakel an. Wenn das Kontaktloch hinter der Galliumwalze hervortritt, dann zieht sich an der Stelle des Kontaktloches hinter dem Gallium 3 ein Gallium-Faden 10 her. Da das Gallium im Bereich des Kontaktloches benetzt, ist der Winkel, den die Tangentialebene an die Oberfläche dieses Galliumfadens 10 an der Berandung der Kontaktfläche zwischen Galliumfaden 10 und Metallisierung 6 des Kontaktloches mit der freien Oberfläche des Bauelementes 5 bildet, größer als 90°. Der Galliumfaden 10 wird aus dem restlichen Gallium 3 herausgezogen, bis die Galliumwalze sich soweit von dem Kontaktloch entfernt hat, daß das Gallium zwischen dem Kontaktloch und der Walze sich einschnürt und schließlich ein separater Anteil des Galliums als Füllung des Kontaktloches übrigbleibt. Die Oberfläche dieser Füllung bildet den in Fig. 2 eingezeichneten Meniskus 8.

Dieser Ablauf ist in der Fig. 6 verdeutlicht, die eine vergrößerte Aufsicht etwa auf den in Fig. 1 gestrichelt eingezeichneten Ausschnitt zeigt. Die Lage des in Fig. 5 gezeichneten Schnittes ist in Fig. 6 eingezeichnet. In dieser Fig. 6 sind wieder die Rakel 1, der Adhäsionsstreifen 2, die Walze des Flüssigmetalles 3 und das Bauelement 5 eingezeichnet. Zusätzlich ist hier der aus der Walze herausgezogene Faden 10 des Flüssigmetalles dargestellt. Zwischen dem in lotrechter Aufsicht etwa kreisförmigen, über dem Kontaktloch befindlichen Anteil dieses Fadens 10 und der Galliumwalze schnürt sich das Gallium ein. Wenn der Abstand zwischen dem Kontaktloch und der Rakel größer wird, wird diese Einschnürung zunehmend enger, bis die Verbindung zwischen der Galliumwalze und der Füllung des Kontaktloches ganz abreißt. Das Kontaktloch ist dann gefüllt und die gesamte angrenzende benetzbare Fläche (oberer Rand der Metallisierung 6) ist benetzt. Die Abschnürung des Galliumfadens ist dadurch erklärbar, daß der Krümmungsradius des Fadens 10 über dem Kontaktloch zunächst etwa dem Radius des Kontaktloches entspricht und damit wesentlich kleiner ist als der Krümmungsradius der Galliumwalze. Folglich ist der Druck in dem Faden wesentlich höher als in der Walze unter der Rakel. Dadurch wird solange Gallium in die Walze zurückgepreßt, bis der Krummungsradius über dem Kontaktloch dem Krümmungsradius der Walze entspricht. Wenn die Rakel von dem Kontaktloch wegbewegt wird, schnürt sich der Faden von der Seite her ab und hinterläßt ein sauber gefülltes Kontaktloch mit einem flachen Meniskus, der auf einfache Weise genau reproduzierbar ist.

Der gleiche physikalische Mechanismus verhindert, daß an Stellen kleiner Inhomogenitäten in der nicht benetzbaren Polyimidoberfläche zu viel Flüssigmetall hängenbleibt; denn je kleiner diese Stellen sind, umso kleiner sind die lokalen Krümmungsradien der Flüssigkeitsoberfläche und umso größer ist der lokale Druck, der die Flüssigkeit in die Walze zurücktreibt und das Auslaufen von Flüssigmetall in die Inhomogenitäten verhindert.

Um möglichst gleichmäßige Verhältnisse garantieren zu können, muß das Volumen in der Walze an der unteren Längskante der Rakel groß sein gegenüber dem Gesamtvolumen der zu füllenden Kontaktlöcher. Sollte ein einmaliges Eintauchen der Rakel in einen Vorrat des Flüssigmetalles vor der Beschichtung des Wafers nicht ausreichen, um eine ausreichend große Walze an der Unterkante der Rakel zu bilden, dann kann die Rakel z. B. über Kapillarkanäle mit einem Reservoir von Gallium verbunden werden. Alternativ kann eine Rakel verwendet werden, die an der dem Adhäsionsstreifen abgewandten Seite mit einem Kanalsystem (z. B. eine rauhe Beschichtung oder ein Kapillarsystem) versehen ist, das genügend Gallium aufnehmen und während des Füllens der Kontaktlöcher abgeben kann, so daß die Galliumwalze stets ein ausreichendes Volumen besitzt.

Die Höhe des sich ergebenden Meniskus 8 der Kontaktlochfüllung ist abhängig von dem Abstand, in dem die Rakel über der Oberseite des Bauelementes bewegt wird. Die Galliumwalze bildet beidseitig angrenzend an die Auflagefläche der Walze auf der Oberseite des Bauelementes näherungsweise einen Ausschnitt aus einem Zylindermantel. Der reziproke Wert des einen Hauptkrümmungsradius ist daher 0. Der Meniskus der Kontaktlochfüllung ist eine Kugelkalotte, so daß die beiden Hauptkrümmungsradien gleich sind. Aus der Gleichheit der den beiden Oberflächenformen entsprechenden inneren Drücke in den Flüssigkeiten resultiert daher, daß der Krümmungsradius des Meniskus über einem zylindrischen Kontaktloch etwa das Doppelte des Krummungsradius am Rand der Auflagefläche der Galliumwalze ist. Im Fall von Gallium mit einer Dichte von 5907 kg/m³ und einer Oberflächenspannung von 0,718 N/m beträgt der Krümmungsradius der Galliumwalze einige Millimeter, wenn die Rakel in einem Abstand von 1 mm von der Oberfläche des Bauelementes geführt wird. Nimmt man einen Krümmungsradius von 2 mm für den Meniskus an, ragt dieser über ein Kontaktloch mit dem Durchmesser von 5 µm nur 1,56 nm hinaus. Man kann also die Kontakt löcher mit einem nahezu ebenen Abschluß füllen. Das ist wichtig, wenn man vermeiden will, daß beim Zusammenfügen der Schaltungsebenen Gallium in den Spalt zwischen den Schaltungsebenen gepreßt wird, was zu Kurzschlüssen führen kann.

Bringt man die Rakel 1 dagegen bis unter 10 µm dicht an die Oberfläche des Bauelementes heran und verhindert gleichzeitig, daß die Seitenflächen der Rakel benetzt werden (wie in Fig. 4 dargestellt), dann wird die Walze zusammengedrückt, und an den die Walze in Bewegungsrichtung begrenzenden Oberflächen erhält man einen Krümmungsradius, der dem halben Abstand zwischen Rakel und Bauelement entspricht. Entsprechend steigt der Druck in der Flüssigkeit, und der Krümmungsradius der Menisken über den Kontaktlöchern sinkt. So lassen sich bei dem angegebenen Durchmesser von 5 µm für die Kontaktlöcher Meniskushöhen bis in den Bereich von um reproduzierbar einstellen. Die Flüssigkontakte ragen dann relativ weit über die Oberfläche hinaus, was z. B. wünschenswert ist, um Welligkeiten in der Oberfläche der zu kontaktierenden weiteren Schaltungsebene auszugleichen. Das ist z. B. insbesondere bei einer reversiblen Kontaktierung zu Testzwecken vorteilhaft. Zum Füllen der Kontaktlöcher kann im Prinzip jede elektrisch leitende Flüssigkeit verwendet werden. Besonders vorteilhaft ist ein Flüssigmetall wie z. B. das vorstehend genannte Gallium.

## Patentansprüche

1. Verfahren zum Herstellen von Flüssigkontakten (7) in Kontaktlöchern auf einer Oberseite eines Halbleiterbauelementes (5), wobei diese Oberseite mit einem ersten für diese Flüssigkontakte (7) vorgesehenen Material (3) nicht benetzbar ist und die Wandungen und Ränder dieser Kontaktlöcher mit diesem ersten Material (3) benetzbar sind,
bei dem das Füllen dieser Kontaktlöcher in der Weise geschieht, daß
a) das für die Flüssigkontakte (7) vorgesehene erste Material (3) mittels einer Rakel (1) auf diese Oberseite aufgebracht wird, wobei sich an einer Längskante dieser Rakel (1) ein Adhäsionsstreifen (2) befindet, der aus einem zweiten Material ist, das von dem für die Flüssigkontakte (7) vorgesehenen ersten Material (3) benetzt wird,
b) diese Rakel (1) dabei mit dieser Längskante in einem Abstand über diese Oberseite bewegt wird, und
c) das für die Flüssigkontakte (7) vorgesehene erste Material (3) walzenförmig zwischen diesem Adhäsionsstreifen (2) und der Oberfläche des Bauelementes (5) bewegt wird.

2. Verfahren nach Anspruch 1,
bei dem eine Rakel (1) verwendet wird, deren Adhäsionsstreifen (2) auf beiden Seitenflächen der Rakel (1) an die über die Oberseite des Bauelementes bewegte Längskante angrenzende Streifen umfaßt.

3. Verfahren nach Anspruch 1 oder 2,
bei dem vor dem Aufbringen des für die Flüssigkontakte (7) vorgesehenen ersten Materials (3) die Oberseite des Bauelementes (5) zwischen den Kontakt löchern mit einer passivierenden Schicht (9) bedeckt wird, die von dem für die Flüssigkontakte (7) vorgesehenen ersten Material (3) nicht benetzt wird.

4. Verfahren nach einem der Ansprüche 1 bis 3,
bei dem für die Flüssigkontakte (7) Gallium und für den Adhäsionsstreifen (2) SiO₂ verwendet wird.

5. Verfahren nach einem der Ansprüche 1 bis 4,
bei dem vor dem Aufbringen des für die Flüssigkontakte (7) vorgesehenen ersten Materials (3) die Wandung und der Rand der Kontaktlöcher mit einer Metallisierung (6) bedeckt wird, die von dem für die Flüssigkontakte (7) vorgesehenen ersten Material (3) benetzt wird.

6. Verfahren nach Anspruch 5,
bei dem für die Flüssigkontakte (7) Gallium und für die Metallisierungen (6) Kupfer verwendet wird.

7. Verfahren nach einem der Ansprüche 1 bis 6,
bei dem eine Rakel (1) verwendet wird, die in einem Bereich außerhalb des Adhäsionsstreifens (2) mit einem Kanalsystem zur Aufnahme zusätzlichen für die Flüssigkontakte vorgesehenen Materiales versehen ist.

## Claims

1. Method for producing liquid contacts (7) in contact holes on a top side of a semiconductor component (5), said top side not being wettable by a first material (3) provided for said liquid contacts (7), and the walls and edges of said contact holes being wettable by said first material (3),
in which said contact holes are filled in such a way that
a) the first material (3) provided for the liquid contacts (7) is applied to said top side by means of a doctor blade (1), there being situated on a longitudinal edge of said doctor blade (1) an adhesion strip (2) which is made of a second material which is wetted by the first material (3) provided for the liquid contacts (7),
b) said doctor blade (1) is moved here by said longitudinal edge at a distance over said top side, and
c) the first material (3) provided for the liquid contacts (7) is moved in the form of a cylinder between said adhesion strip (2) and the surface of the component (5).

2. Method according to Claim 1,
in which use is made of a doctor blade (1) whose adhesion strip (2) comprises, on both side surfaces of the doctor blade (1), strips adjoining the longitudinal edge which is moved over the top side of the component.

3. Method according to Claim 1 or 2,
in which, prior to the application of the first material (3) provided for the liquid contacts (7), the top side of the component (5) is covered between the contact holes with a passivating layer (9), which is not wetted by the first material (3) provided for the liquid contacts (7).

4. Method according to one of Claims 1 to 3,
in which gallium is used for the liquid contacts (7) and SiO₂ is used for the adhesion strip (2).

5. Method according to one of Claims 1 to 4,
in which, prior to the application of the first material (3) provided for the liquid contacts (7), the wall and the edge of the contact holes are covered with a metallization layer (6), which is wetted by the first material (3) provided for the liquid contacts (7).

6. Method according to Claim 5,
in which gallium is used for the liquid contacts (7) and copper is used for the metallization layers (6).

7. Method according to one of Claims 1 to 6,
in which use is made of a doctor blade (1) which is provided, in a region outside the adhesion strip (2), with a channel system for receiving additional material provided for the liquid contacts.

## Revendications

1. Procédé de fabrication de contacts liquides (7) dans des trous de métallisation sur une face supérieure d'un composant semi-conducteur (5), dans lequel cette face supérieure n'est pas imprégnable par une première matière (3) prévue pour ces contacts liquides (7) et les parois et bords de ces trous de métallisation sont imprégnables par cette première matière (3),
dans lequel le remplissage de ces trous de métallisation se produit de manière à ce que
a) la première matière (3) prévue pour les contacts liquides (7) soit appliquée sur cette face supérieure à l'aide d'une raclette (1), une bande adhérente (2) se trouvant à une arête longitudinale de cette raclette (1), composée d'une deuxième matière, qui est imprégnée par la première matière (3) prévue pour les contacts liquides (7),
b) cette raclette (1) soit déplacée dans ce cas par cette arête longitudinale dans un intervalle au-dessus de cette face supérieure, et
c) la première matière (3) prévue pour les contacts liquides (7) soit déplacée en forme de rouleau entre cette bande adhérente (2) et la surface du composant (5).

2. Procédé selon la revendication 1, dans lequel est utilisée une raclette (1), dont la bande adhérente (2) comprend sur les deux surfaces latérales de la raclette (1) des bandes contiguës à l'arête longitudinale déplacée au-dessus de la face supérieure du composant.

3. Procédé selon la revendication 1 ou 2, dans lequel, avant l'application de la première matière (3) prévue pour les contacts liquides (7), la face supérieure du composant (5) est recouverte d'une couche rendue passive (9) entre les trous de métallisation, qui n'est pas imprégnée par la première matière (3) prévue pour les contacts liquides (7).

4. Procédé selon l'une des revendications 1 à 3, dans lequel on utilise du gallium pour les contacts liquides (7) et du SiO₂ pour la bande adhérente (2).

5. Procédé selon l'une des revendications 1 à 4, dans lequel, avant l'application de la première matière (3) prévue pour les contacts liquides (7), la paroi et le bord des trous de contact sont recouverts d'une métallisation (6), qui est imprégnée par la première matière (3) prévue pour les contacts liquides (7).

6. Procédé selon la revendication 5, dans lequel on utilise du gallium pour les contacts liquides (7) et du cuivre pour les métallisations (6).

7. Procédé selon l'une des revendications 1 à 6, dans lequel est utilisée une raclette (1), qui est pourvue dans une zone située à l'extérieur de la bande adhérente (2) d'un système de canal pour recevoir une matière supplémentaire prévue pour les contacts liquides.
